# EUROPEAN PATENT APPLICATION

(11) **EP 4 804 748 A1**
(43) Date of publication of application: **09.09.2026**
(21) Application number: 26162741.8
(22) Date of filing: 05.03.2026
(51) Int. Cl.: H05K 7/20

(54) **AIRCRAFT POWERPLANT MODULE WITH INTEGRATED ELECTRONICS AND FLUID CIRCUIT**

(30) Priority: 05.03.2025 US 202519070786
(71) Applicant: RTX Corporation, Farmington, CT 06032 (US)
(72) Inventor: CLARK, Thomas E., Wells, 04090 (US); YAZICI, Murat, Glastonbury, 06033 (US)
(74) Representative: Dehns

(57) **Abstract**

An assembly for an aircraft powerplant includes an electric device (108A, 108B) and a closed loop fluid circuit (142A, 142B). The electric device includes a device housing (120A, 120B) and electrical circuitry (122A, 122B) housed within an interior of the device housing. The closed loop fluid circuit is configured to cool the electrical circuitry and includes a circuit path (146A, 146B) and a plurality of circuit components (148, 150, 152 and 154). The circuit path extends through the circuit components. Each of the circuit components are at least partially housed within the interior of the device housing. The circuit components may include a heat exchanger (150A, 150B).

## Description

### BACKGROUND OF THE INVENTION

### 1. Technical Field

This invention relates generally to an aircraft and, more particularly, to a working fluid system for a powerplant of the aircraft.

### 2. Background Information

An aircraft powerplant includes various components which utilize fluid cooling during aircraft powerplant operation. Various fluid cooling systems and methods are known in the art. While these known cooling systems and methods have various benefits, there is still room in the art for improvement.

### SUMMARY OF THE INVENTION

According to an aspect of the present invention, an assembly is provided for an aircraft powerplant. This assembly includes an electric device and a closed loop fluid circuit. The electric device includes a device housing and electrical circuitry housed within an interior of the device housing. The closed loop fluid circuit is configured to cool the electrical circuitry. The closed loop fluid circuit includes a circuit path and a plurality of circuit components. The circuit path extends through the circuit components. Each of the circuit components are at least partially housed within the interior of the device housing. The circuit components may include a heat exchanger.

According to another aspect of the present invention, another assembly is provided for an aircraft powerplant. This assembly includes an electric device and a fluid circuit. The electric device includes a device housing and one or more electronic components housed within an interior of the device housing. The fluid circuit includes a liquid working fluid and a heat exchanger. The heat exchanger is configured to transfer heat energy between the one or more electronic components and the liquid working fluid. The fluid circuit is integrated with the electric device as a standalone module.

According to still another aspect of the present invention, another assembly is provided for an aircraft powerplant. This assembly includes an electric device and a fluid circuit. The electric device includes a device housing and one or more electronic components housed within an interior of the device housing. The device housing extends circumferentially about an axis between opposing circumferential ends of the device housing. The fluid circuit is configured to cool the one or more electronic components. The fluid circuit includes a heat exchanger at least partially disposed in the device housing.

According to still another aspect of the present invention, there is provided an aircraft powerplant comprising any of the above assemblies.

Each of the above aspects may contain one or more or all of the following features in any combination thereof.

The fluid circuit may also include a circuit path and a fluid pump. The fluid pump may be configured to circulate the liquid working fluid within the circuit path.

The electric device may also include electrical circuity. The electrical circuitry may include the one or more electronic components.

The electric device may also include an electrical distribution bus. The electrical distribution bus may include the one or more electronic components.

The heat exchanger may include a cooling plate. The electrical circuitry may be thermally coupled to the cooling plate within the interior of the device housing.

The electrical circuitry may be mounted to the cooling plate.

The heat exchanger may also include a cooling element projecting into an environment external to the electric device.

The heat exchanger may be configured as or otherwise include a radiator with a plurality of cooling elements disposed in an environment external to the electric device.

The assembly may also include a cooling plate. The electrical circuitry may be thermally coupled to the cooling plate within the interior of the device housing. The circuit path may extend through the cooling plate.

The cooling plate may be formed integral with the radiator.

The circuit components may also include a fluid reservoir.

The circuit components may also include a fluid pump.

The circuit components may also include a fluid reservoir fluidly coupled between the heat exchanger and the fluid pump along the circuit path.

The circuit path may be contained within the interior of the device housing.

The assembly may be configured as a line replaceable unit.

The assembly may also include a line replaceable unit that includes the electric device and the closed loop fluid circuit.

The closed loop fluid circuit may also include a fluid reservoir or a fluid pump disposed outside of the electric device.

The electric device may be configured as an electronic controller.

The assembly may also include an electric machine configurable as an electric motor and/or an electric generator. The electronic controller may be configured to control operation of the electric machine.

The assembly may also include a rotating structure comprising a bladed rotor. The rotating structure may be operatively coupled to the electric machine.

The assembly may also include a turbine engine comprising an engine case. The electric device may be mounted to the engine case.

The engine case may extend circumferentially about an axis. The electric device may follow a contour of the engine case circumferentially about the axis.

The electric device may have a curved sectional geometry.

The present invention may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a partial schematic illustration of an aircraft propulsion system with a ducted propulsor rotor.
FIG. 2 is a schematic illustration of a portion of the aircraft propulsion system at an electric machine system.
FIG. 3 is a schematic illustration of a portion of the aircraft propulsion system at a fluid circuit of a working fluid system.
FIGS. 4A and 4B are partial schematic illustrations of the fluid circuit at various locations along a bypass flowpath.
FIG. 5 is a partial schematic illustration of the fluid circuit along a passage receiving air from an air source.
FIG. 6 is a partial schematic illustration of the fluid circuit along an exterior of the aircraft propulsion system.
FIG. 7 is a schematic illustration of a portion of the aircraft propulsion system at another fluid circuit.
FIG. 8 is a schematic illustration of the fluid circuit mounted to a structure of the aircraft propulsion system.
FIGS. 9A-9C are schematic illustrations of a controller and a heat exchanger with various arrangements.
FIG. 10 is a partial schematic illustration of the aircraft propulsion system with an open propulsor rotor.

### DETAILED DESCRIPTION

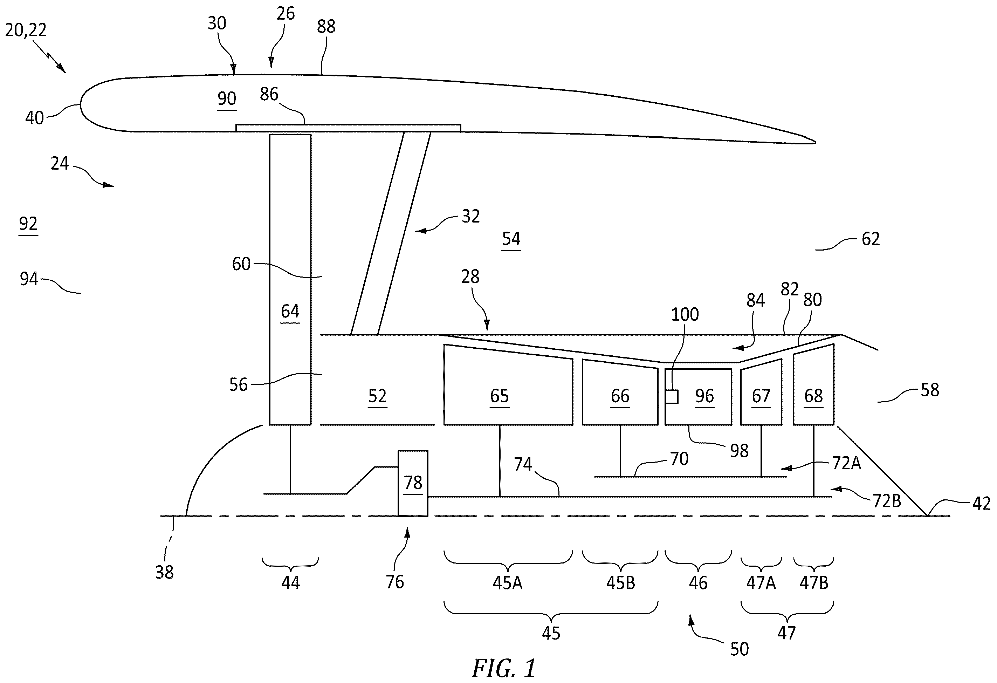

FIG. 1 illustrates a powerplant 20 for an aircraft. The aircraft may be an airplane, a drone (e.g., an unmanned aerial vehicle (UAV)) or any other manned or unmanned aerial vehicle or system. For ease of description, the aircraft powerplant 20 is described below as a propulsion system 22 for the aircraft and, more particularly, as a turbofan propulsion system. The aircraft powerplant 20 of the present invention, however, is not limited to such an exemplary propulsion system. The aircraft propulsion system 22, for example, may alternatively be configured as a turbojet propulsion system, a turboprop propulsion system, a turboshaft propulsion system, a propfan propulsion system, a pusher fan propulsion system, or any other type of ducted and/or open rotor propulsion system. Moreover, the aircraft powerplant 20 is not limited to propulsion system applications. The aircraft powerplant 20, for example, may also (or alternatively) be configured as an electrical power system for the aircraft; e.g., an auxiliary power unit (APU).

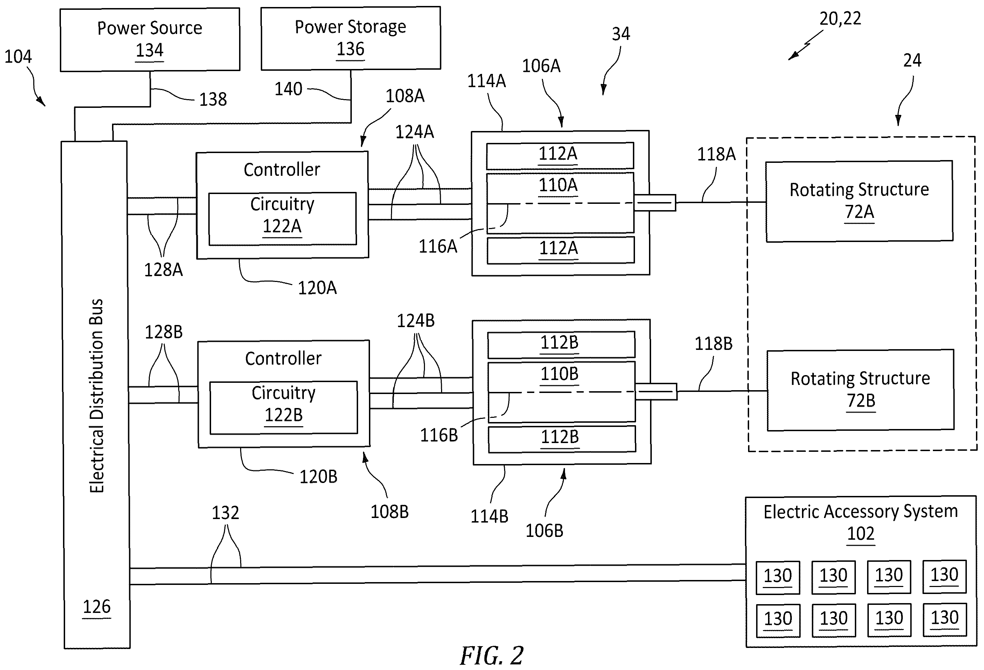

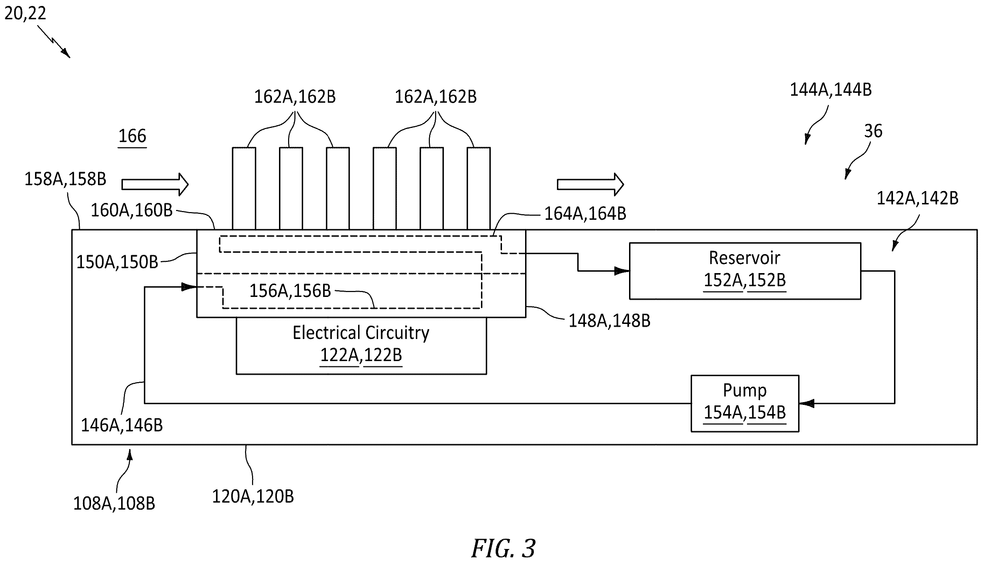

The aircraft propulsion system 22 includes a gas turbine engine 24 (e.g., a turbofan engine) housed within a stationary propulsion system housing 26, which propulsion system housing 26 of FIG. 1 includes an inner housing structure 28, an outer housing structure 30 and a guide vane structure 32 (e.g., a fan exit guide vane (FEGV) structure) extending radially between and connected to the inner housing structure 28 and the outer housing structure 30. The aircraft propulsion system 22 also includes an electric machine system 34 (see FIG. 2) and a working fluid system 36 (see FIG. 3). The aircraft propulsion system 22 extends axially along an axis 38 between an axial upstream, forward end 40 of the aircraft propulsion system 22 and an axial downstream, aft end 42 of the aircraft propulsion system 22. Briefly, the propulsion system axis 38 may be a centerline axis of the aircraft propulsion system 22, the turbine engine 24 and/or one or more of its members. The propulsion system axis 38 may also or alternatively be a rotational axis for one or more members of the turbine engine 24.

The aircraft propulsion system 22 and its turbine engine 24 of FIG. 1 include a propulsor section 44 (e.g., a fan section), a compressor section 45, a combustor section 46 and a turbine section 47. The compressor section 45 of FIG. 1 includes a low pressure compressor (LPC) section 45A and a high pressure compressor (HPC) section 45B. The turbine section 47 of FIG. 1 includes a high pressure turbine (HPT) section 47A and a low pressure turbine (LPT) section 47B. At least (or only) the LPC section 45A, the HPC section 45B, the combustor section 46, the HPT section 47A and the LPT section 47B collectively form a core 50 (e.g., a gas generator) of the turbine engine 24. The aircraft propulsion system 22 and its turbine engine 24 of FIG. 1 also include a core flowpath 52 (e.g., an annular core flowpath) and a bypass flowpath 54 (e.g., an annular bypass flowpath). The core flowpath 52 extends sequentially through the LPC section 45A, the HPC section 45B, the combustor section 46, the HPT section 47A and the LPT section 47B from an airflow inlet 56 into the core flowpath 52 to a combustion products exhaust 58 out from the core flowpath 52. The bypass flowpath 54 extends through a bypass duct from an airflow inlet 60 into the bypass flowpath 54 to an airflow exhaust 62 from the bypass flowpath 54, where the bypass duct may be formed by the inner housing structure 28 and the outer housing structure 30. The bypass flowpath 54 and its bypass duct are configured to bypass (e.g., are disposed radially outboard of and extend along) the engine core 50 and the inner housing structure 28.

The propulsor section 44, the LPC section 45A, the HPC section 45B, the combustor section 46, the HPT section 47A and the LPT section 47B may be arranged sequentially along the propulsion system axis 38 within the propulsion system housing 26. The propulsor section 44 includes a bladed propulsor rotor 64; e.g., a fan rotor. The LPC section 45A includes a bladed low pressure compressor (LPC) rotor 65. The HPC section 45B includes a bladed high pressure compressor (HPC) rotor 66. The HPT section 47A includes a bladed high pressure turbine (HPT) rotor 67. The LPT section 47B includes a bladed low pressure turbine (LPT) rotor 68. Each of these engine rotors 64-68 includes a rotor base (e.g., a disk or a hub) and a plurality of rotor blades (e.g., airfoils, vanes, etc.). The rotor blades may be arranged into one or more stages axially along the respective engine rotor 64-68. The rotor blades in each stage are arranged and may be equispaced circumferentially around the respective rotor base in an annular array. Each of the rotor blades is connected to the respective rotor base. The rotor blades, for example, may be formed integral with or mechanically fastened, welded, brazed and/or otherwise attached to the respective rotor base. Each of the rotor blades projects spanwise (e.g., radially) out from the respective rotor base to a distal tip of the respective rotor blade.

The HPC rotor 66 is coupled to and rotatable with the HPT rotor 67. The HPC rotor 66 of FIG. 1, for example, is connected to the HPT rotor 67 through a high speed shaft 70. At least (or only) the HPC rotor 66, the HPT rotor 67 and the high speed shaft 70 collectively form a high speed rotating structure 72A; e.g., a high speed spool of the turbine engine 24 and its engine core 50. This high speed rotating structure 72A of FIG. 1 and its members 66, 67 and 70 are rotatable about the propulsion system axis 38. However, it is contemplated the high speed rotating structure 72A may alternatively be rotatable about another axis radially and/or angularly offset from the rotational axis of the propulsor rotor 64 and/or the centerline axis of the turbine engine 24.

The LPC rotor 65 is coupled to and rotatable with the LPT rotor 68. The LPC rotor 65 of FIG. 1, for example, is connected to the LPT rotor 68 through a low speed shaft 74. At least (or only) the LPC rotor 65, the LPT rotor 68 and the low speed shaft 74 collectively form a low speed rotating structure 72B; e.g., a low speed spool of the turbine engine 24 and its engine core 50. This low speed rotating structure 72B of FIG. 1 and its members 65, 68 and 74 are rotatable about the propulsion system axis 38. However, it is contemplated the low speed rotating structure 72B may alternatively be rotatable about another axis radially and/or angularly offset from the rotational axis of the propulsor rotor 64 and/or the centerline axis of the turbine engine 24.

The low speed rotating structure 72B is coupled to the propulsor rotor 64 through a propulsor drivetrain 76. The propulsor drivetrain 76 may be configured as a geared drivetrain, where a geartrain 78 (e.g., a transmission, a speed change device, an epicyclic geartrain, etc.) is disposed between and operatively couples the propulsor rotor 64 to the low speed rotating structure 72B and its LPT rotor 68. With this arrangement, the propulsor rotor 64 may rotate at a different (e.g., slower) rotational speed than the low speed rotating structure 72B and its LPT rotor 68. Here, the propulsor rotor 64 and the low speed rotating structure 72B may rotate in a common (the same) direction about the propulsion system axis 38 or in opposite directions about the propulsion system axis 38 depending, for example, upon the specific configuration of the geartrain 78. Alternatively, the propulsor drivetrain 76 may be configured as a direct-drive drivetrain, where the geartrain 78 is omitted. With such an arrangement, the propulsor rotor 64 rotates at a common (the same) rotational speed as the low speed rotating structure 72B and its LPT rotor 68.

The inner housing structure 28 of FIG. 1 includes an inner case 80 (e.g., a core case) for the turbine engine 24, an inner nacelle structure 82 (sometimes referred to as an inner fixed structure (IFS)) and an internal inner housing compartment 84 (e.g., an engine core compartment). The inner case 80 is disposed radially outboard of, extends axially along and may circumscribe one or more or all of the engine sections 45A-47B and the engine rotors 65-68. The inner case 80 may thereby house and provide a support structure for the respective engine sections 45A-47B and the engine rotors 65-68. The inner nacelle structure 82 is configured to provide an aerodynamic cover over the engine core 50 and its inner case 80. At least (or only) the inner housing structure 28 and its inner nacelle structure 82 may collectively form a radial inner peripheral boundary of the bypass flowpath 54. The inner housing compartment 84 of FIG. 1 is formed by and is disposed radially between the inner case 80 and an inner barrel of the inner nacelle structure 82.

The outer housing structure 30 of FIG. 1 includes an outer case 86 (e.g., a fan case) for the turbine engine 24, an outer nacelle structure 88 and an internal outer housing compartment 90. The outer case 86 is disposed radially outboard of, extends axially along and may circumscribe the propulsor section 44 and its propulsor rotor 64. The outer case 86 may thereby house and may be configured as a containment structure for the propulsor section 44 and its propulsor rotor 64. The outer nacelle structure 88 is configured to provide an aerodynamic cover over the outer case 86. At least (or only) the outer housing structure 30 and its outer nacelle structure 88 may collectively form a radial outer peripheral boundary of the bypass flowpath 54. The outer housing compartment 90 of FIG. 1 is formed by and is disposed radially between the outer case 86 and the outer nacelle structure 88; e.g., outer cowls of the outer nacelle structure 88.

During operation of the aircraft propulsion system 22 of FIG. 1, ambient air from an environment 92 external to the aircraft and its aircraft propulsion system 22 enters the aircraft propulsion system 22 and its turbine engine 24 through an airflow inlet 94. This air is propelled by the rotating propulsor rotor 64 in a downstream, aft direction towards the propulsion system aft end 42.

An outer stream of the air propelled by the rotating propulsor rotor 64 is directed into the bypass flowpath 54 through its bypass inlet 60, which air entering the bypass flowpath 54 may be referred to as "bypass air". The guide vane structure 32 conditions (e.g., straightens out, de-swirls, etc.) the flow of the bypass air within the bypass duct. This conditioned bypass air is subsequently directed out of the aircraft propulsion system 22 through the bypass exhaust 62 to provide forward thrust. The propulsion of the bypass air may account for a majority of the forward thrust generated by the aircraft propulsion system 22 and its turbine engine 24 of FIG. 1.

An inner stream of the air propelled by the rotating propulsor rotor 64 is directed into the core flowpath 52 through its core inlet 56, which air entering the core flowpath 52 may be referred to as "core air". This core air is compressed by the LPC rotor 65 and the HPC rotor 66 and is directed into a combustion chamber 96 (e.g., annular combustion chamber) of a combustor 98 (e.g., annular combustor) in the combustor section 46. Fuel is injected into the combustion chamber 96 by one or more fuel injectors 100 and mixed with the compressed core air to provide a fuel-air mixture. This fuel-air mixture is ignited and combustion products thereof flow through and sequentially drive rotation of the HPT rotor 67 and the LPT rotor 68. The rotation of the HPT rotor 67 and the LPT rotor 68 respectively drive rotation of the HPC rotor 66 and the LPC rotor 65 and, thus, compression of the air received from the core inlet 56. The rotation of the LPT rotor 68 also drives rotation of the propulsor rotor 64 through the propulsor drivetrain 76.

Referring to FIG. 2, the electric machine system 34 is electrically coupled to an optional electric accessory system 102 and an electrical system 104 for the aircraft and its aircraft propulsion system 22. The electric machine system 34 of FIG. 2 includes one or more electric machines 106A and 106B (generally referred to as "106") and one or more electric machine (EM) controllers 108A and 108B (generally referred to as "108"). For ease of description, each electric machine 106 of FIG. 2 is described below as being electrically coupled to, controlled by and/or otherwise associated with a single, dedicated EM controller 108. However, it is contemplated a single EM controller may alternatively be electrically coupled to, may control and/or may otherwise be associated with multiple electric machines. It is also contemplated multiple EM controllers may be electrically coupled to, may control and/or may otherwise be associated with the single electric machine.

Each electric machine 106A, 106B of FIG. 2 includes an electric machine rotor 110A, 110B (generally referred to as "110"), an electric machine stator 112A, 112B (generally referred to as "112") and an electric machine housing 114A, 114B (generally referred to as "114"); e.g., a case. The machine rotor 110A, 110B is rotatable about a rotational axis 116A, 116B (generally referred to as "116") of the respective machine rotor 110A, 110B, which electric machine (EM) axis 116 may also be a centerline axis of the respective electric machine 106. The machine stator 112 of FIG. 2 is radially outboard of and circumscribes the machine rotor 110. With this arrangement, each electric machine 106 is configured as a radial flux electric machine. The electric machines 106 of the present invention, however, are not limited to such an exemplary rotor-stator configuration nor to radial flux arrangements. The machine rotor 110, for example, may alternatively be radially outboard of and circumscribe the machine stator 112. In another example, the machine rotor 110 may be axially next to the machine stator 112 configuring the electric machine 106 as an axial flux electric machine. Referring again to FIG. 2, the machine rotor 110 and the machine stator 112 are at least partially or completely housed within an interior of the machine housing 114.

Each electric machine 106A, 106B may be operatively coupled to a respective one of the engine rotating structures 72A, 72B (generally referred to as "72"). Each machine rotor 110A, 110B of FIG. 2, for example, is mechanically coupled to and rotatable with the respective engine rotating structure 72A, 72B through an engine-electric machine drivetrain 118A, 118B (generally referred to as "118"). This engine-electric machine drivetrain 118 may be configured as or otherwise include a shaft, a tower shaft assembly, an accessory gearbox, an angle gearbox, and/or the like. For ease of description, each machine rotor 110 of FIG. 2 is described below as being coupled to and rotatable with a unique one of the engine rotating structures 72 of the turbine engine 24. However, it is contemplated multiple machine rotors may alternatively be coupled to and rotatable with a common engine rotating structure; e.g., 72A or 72B. It is also contemplated a single one of the machine rotors may be coupled to and rotatable with multiple engine rotating structures, directly or through another device such as a differential or a clutch system. In addition, while the electric machines 106 are described above as being coupled to the engine rotating structures 72, it is contemplated the machine rotor 110 of one or more of the electric machines 106 may also or alternatively be operatively coupled to another rotating device through the engine-electric machine drivetrain 118 such as, but not limited to, a pump rotor, an auxiliary compressor rotor, an actuator rotor, or the like.

Each electric machine 106 of FIG. 2 may be configurable as an electric motor and/or an electric generator; e.g., an electric motor-generator. For example, during a respective motor mode of operation, each electric machine 106 may operate as the electric motor to convert electricity received from the aircraft electrical system 104 into mechanical power. The machine stator 112, for example, may generate an electromagnetic field with the machine rotor 110 using a current of electricity received from the aircraft electrical system 104 through the respective EM controller 108. This electromagnetic field may drive rotation of the machine rotor 110. The machine rotor 110, in turn, may provide mechanical power to and drive rotation of the respective engine rotating structure 72 through the respective engine-electric machine drivetrain 118. This mechanical power may be provided to boost power or completely power the rotation of the respective engine rotating structure 72. By contrast, during a respective generator mode of operation, each electric machine 106 may operate as the electric generator to convert mechanical power received from the respective engine rotating structure 72 into electricity. Rotation of the machine rotor 110, for example, may be rotationally driven by rotation of the respective engine rotating structure 72 through the engine-electric machine drivetrain 118. The rotation of the machine rotor 110 may generate an electromagnetic field with the machine stator 112, and the machine stator 112 may convert energy from the electromagnetic field into electricity. The electric machine 106 may then provide a current of electricity to the aircraft electrical system 104 through the respective EM controller 108 for storage and/or further use. The electric machines 106 of the present invention, however, are not limited to such exemplary operation. For example, one or more of the electric machines 106 may each alternatively be configured as a dedicated electric generator; e.g., without the electric motor functionality. In another example, one or more of the electric machines 106 may each alternatively be configured as a dedicated electric motor; e.g., without the electric generator functionality.

Each EM controller 108A, 108B includes a controller housing 120A, 120B (generally referred to as "120") and internal controller circuitry 122A, 122B (generally referred to as "122"). The controller housing 120 may be configured as an enclosed case (e.g., a closed or sealed container) for the respective controller circuitry 122. The controller circuitry 122 is disposed within an interior of the respective controller housing 120; e.g., an internal chamber or other volume(s) within and enclosed by the controller housing 120. The controller circuitry 122 includes various electrical components, connectors and the like. Examples of the electrical components include, but are not limited to, printed circuit board(s) (PCB(s)), electrical inductor(s), electrical inverter(s), electrical amplifier(s), electrical switch(es) (e.g., contactor(s), relay(s), etc.), processing device(s), memory module(s), communication module(s), electrical transformer(s), electrical rectifier(s), and/or the like.

Each EM controller 108A, 108B is electrically coupled to the respective electric machine 106A, 106B through one or more electric cables 124A, 124B (generally referred to as "124"); e.g., high voltage electric cables, power feeder cables, etc. More particularly, the controller circuitry 122 of each EM controller 108 is electrically coupled to the respective electric machine 106 and its machine stator 112 through the respective electric cables 124. Similarly, each EM controller 108A, 108B is electrically coupled to an electrical distribution bus 126 of the aircraft electrical system 104 through one or more electric cables 128A, 128B (generally referred to as "128"); e.g., high voltage electric cables, power feeder cables, etc. More particularly, the controller circuitry 122 of each EM controller 108 is electrically coupled to the aircraft electrical system 104 and its electrical distribution bus 126 through the respective electric cables 128.

Each EM controller 108 and its controller circuitry 122 are configured to control operation of the respective electric machine 106. For example, when operating as the electric motor, each EM controller 108 and its controller circuitry 122 are configured to regulate a flow of electricity from the aircraft electrical system 104 to the respective electric machine 106. This electricity flow regulation may include: (a) turning-on the flow of electricity from the aircraft electrical system 104 to the respective electric machine 106 (e.g., electrically coupling the respective electric machine 106 to the aircraft electrical system 104); (b) turning-off the flow of electricity from the aircraft electrical system 104 to the respective electric machine 106 (e.g., electrically decoupling the respective electric machine 106 from the aircraft electrical system 104); (c) moderating the flow of electricity from the aircraft electrical system 104 to the respective electric machine 106. Here, each EM controller 108 operates as a motor controller. In another example, when operating as the electric generator, each EM controller 108 and its controller circuitry 122 are configured to regulate a flow of electricity from the respective electric machine 106 to the aircraft electrical system 104. This electricity flow regulation may include: (a) turning-on the flow of electricity from the respective electric machine 106 to the aircraft electrical system 104 (e.g., electrically coupling the respective electric machine 106 to the aircraft electrical system 104); (b) turning-off the flow of electricity from the respective electric machine 106 to the aircraft electrical system 104 (e.g., electrically decoupling the respective electric machine 106 from the aircraft electrical system 104); (c) moderating the flow of electricity from the respective electric machine 106 to the aircraft electrical system 104. Here, the EM controller 108 operates as a generator controller.

The electric accessory system 102 includes one or more electric devices 130. The electric devices 130 may include one or more electric actuators, one or more electric pumps, one or more electric valves and/or one or more fluid separator(s) (e.g., de-oiler(s)). The electric actuator(s) may include one or more electric linear actuators and/or one or more electric rotary actuators. The electric pump(s) may include one or more electric liquid pumps and/or one or more electric gas pumps (e.g., electric air compressor(s)). The electric devices 130 of FIG. 2 may be configured as part of one or more sub-systems for the aircraft propulsion system 22 and its turbine engine 24. Examples of these sub-systems include, but are not limited to: a fuel system for delivering the fuel to the fuel injectors 100 (see FIG. 1); a lubrication system for delivering lubricant (e.g., oil) to one or more lubricated components (e.g., bearing(s), gear system(s), seal system(s), etc.) of the aircraft propulsion system 22 and its turbine engine 24; a cooling system for delivering coolant (e.g., liquid coolant, air, etc.) to one or more fluid cooled components of the aircraft propulsion system 22 and its turbine engine 24; and an actuation system for moving one or more adjustable components (e.g., variable guide vanes, a variable area nozzle, etc.) of the aircraft propulsion system 22 and its turbine engine 24. One, some or all of these sub-systems may be discrete (e.g., operationally, mechanically, fluidly, etc. independent) from one another. Alternatively, some of the sub-systems may be integrated to share, for example, a common working fluid such as the lubricant or the fuel. The present invention, however, is not limited to the foregoing exemplary electric devices or sub-systems which may include those electric devices.

Each electric device 130 is electrically coupled to the electrical distribution bus 126 of the aircraft electrical system 104 through one or more electric cables 132 (collectively schematically shown); e.g., high voltage electric cables, low voltage electric cables, power feeder cables, etc. Each electric device 130 may thereby receive a current of electricity from the aircraft electrical system 104 to power operation thereof.

The aircraft electrical system 104 includes the electrical distribution bus 126. This aircraft electrical system 104 may also include a power source 134 and/or a power storage 136. The electrical distribution bus 126 is electrically coupled to each electric machine 106 through the respective EM controller 108. The electrical distribution bus 126 is electrically coupled to each of the electric devices 130. The electrical distribution bus 126 is also electrically coupled to the power source 134 and the power storage 136, respectively schematically shown via lines 138 and 140. With this arrangement, the electrical distribution bus 126 provides an intermediate connection between the various electrical aircraft propulsion system members 106A (via 108A), 106B (via 108B), 130, 134 and/or 136. The power source 134 may be an electric generator powered by the turbine engine 24 or an electric generator powered by another aircraft powerplant; e.g., an engine of a companion aircraft propulsion system, an engine of an auxiliary power unit (APU), a fuel cell system, etc. The power storage 136 is configured to receive electricity from the electrical distribution bus 126 for storage. The power storage 136 is also configured to provide the stored electricity to the electrical distribution bus 126. The power storage 136, for example, may be configured as or otherwise include one or more electricity storage devices; e.g., batteries, super capacitors, etc. With the foregoing aircraft electrical system arrangement, the electrical current provided to one, some or all of the electric devices 130 may be received, through the electrical distribution bus 126, from any one, some or all of the electrical aircraft propulsion system members 106A, 106B, 134 and/or 136. It is also contemplated the electrical current provided to one of the electric machines 106 may be received from another one of the electric machines 106 through the aircraft electrical system 104 and its electrical distribution bus 126.

Referring to FIG. 3, the working fluid system 36 may include a plurality of discrete fluid circuits 142A and 142B (generally referred to as "142"; one schematically shown); e.g., fluidly decoupled circuits, fluidly independent circuits, etc. Each fluid circuit 142A, 142B of FIG. 3 may be dedicated to and is configured to service a respective one of the EM controllers 108A, 108B. The first fluid circuit 142A of FIG. 3, for example, is configured to cool the first electrical circuitry 122A and/or other power electronics within the first EM controller 108A using a first working fluid. This first fluid circuit 142A may also be at least partially or completely integrated with the first EM controller 108A. Similarly, the second fluid circuit 142B of FIG. 3 is configured to cool the second electrical circuitry 122B and/or other power electronics within the second EM controller 108B using a second working fluid. This second fluid circuit 142B may also be at least partially or completely integrated with the second EM controller 108B. Briefly, the first and the second working fluids may each be a liquid working fluid such as, but not limited to, lubricant (e.g., engine oil), coolant (e.g., ammonia or a mixture of glycol and water), hydraulic fluid, or another suitable heat exchange liquid. The first and the second working fluids may have a common composition; e.g., include the same chemical constituent(s). Alternatively, the first and the second working fluids may have different compositions; e.g., may include one or more or all different chemical constituent(s).

By dividing the working fluid system 36 into the discrete fluid circuits 142A and 142B, each fluid circuit 142A, 142B may be individually tuned based on cooling requirements for its serviced EM controller 108A, 108B. In addition, by providing each EM controller 108A, 108B with its separate fluid circuit 142A, 142B, potential debris, flow blockages, etc. associated with one of the fluid circuits 142A, 142B will not affect operation of the other fluid circuit 142B, 142A. With this in mind, in an unlikely event a component (e.g., a pump, etc.) of the first fluid circuit 142A (or alternatively the second fluid circuit 142B) fails or is otherwise operationally derated (e.g., reduced in operational capacity, efficiency, etc.), operation of the first EM controller 108A (or alternatively the second EM controller 108B) serviced by that first fluid circuit 142A may also be operationally derated or turned-off; e.g., depowered, disconnected, etc. However, since the second EM controller 108B is serviced by the discrete second fluid circuit 142B, the second EM controller 108B may continue to operate unaffected by the non-operational or derated first fluid circuit 142A. The electric machine system members 106B and 108B of FIG. 2 may thereby be operated to provide redundancy for the derated or turned-off electric machine system members 106A and 108A of FIG. 2, or vice versa.

In addition to the foregoing, by integrating each fluid circuit 142A, 142B of FIG. 3 with the respective serviced EM controller 108A, 108B as described below in further detail, at least (or only) each respective set of the integrated aircraft powerplant components 108A and 142A, 108B and 142B may be configured as or otherwise part of a standalone module 144A, 144B (generally referred to as "144") such as a line replaceable unit (LRU). Each module 144A, 144B and its integrated aircraft powerplant components 108A and 142A, 108B and 142B may thereby be operable to be independently installed, serviced and/or removed from the aircraft propulsion system 22 as a single unit; e.g., separate from the installation, servicing and/or removal of the other module 144 and/or various other aircraft powerplant components located proximate the respective module 144.

Each fluid circuit 142A, 142B of FIG. 3 includes a circuit path 146A, 146B (generally referred to as "146"), which circuit path 146 is discrete (e.g., fluidly decoupled, fluidly independent) from the circuit path 146 of the other fluid circuit 142. Each fluid circuit 142A, 142B includes one or more heat exchangers 148A, 148B (generally referred to as "148") and 150A, 150B (generally referred to as "150"), a working fluid reservoir 152A, 152B (generally referred to as "152") and a working fluid pump 154A, 154B (generally referred to as "154"), where the fluid circuit components 148, 150, 152 and 154 in each fluid circuit 142 of FIG. 3 are structurally and/or operationally independent from the like fluid circuit components 148, 150, 152 and 154 in the other fluid circuit 142. Of course, it is contemplated one or more of the fluid circuits 142 may (or may not) also each include one or more additional components arranged along its respective circuit path 146 such as, but not limited to, filter(s), sensor(s), additional heat exchanger(s), additional powerplant component(s), valve(s), pump(s), etc.

In each fluid circuit 142, the electronics heat exchanger 148, the working fluid-to-air (WFA) heat exchanger 150, the fluid reservoir 152 and the fluid pump 154 may be arranged inline along the respective circuit path 146. Each circuit path 146 of FIG. 3, for example, extends serially through the electronics heat exchanger 148, the working fluid-to-air heat exchanger 150, the fluid reservoir 152 and the fluid pump 154 in a closed loop. Each fluid circuit 142 may thereby be configured as a closed loop fluid circuit. The present invention, however, is not limited to such an exemplary arrangement. More particularly, it is contemplated the fluid circuit components 148, 150, 152 and 154 in each fluid circuit 142 may be disposed in other arrangements along the respective circuit path 146. For example, while each fluid reservoir 152 is shown in FIG. 3 as being downstream of the heat exchangers 148 and 150 along the respective circuit path 146, it is contemplated the fluid reservoir 152 may alternatively be arranged upstream of one or both of the heat exchangers 148 and/or 150 along the respective circuit path 146.

Each electronics heat exchanger 148 may be configured as or otherwise include a cooling plate for the respective power electronics (e.g., the electrical circuitry 122) to be serviced; e.g., cooled. Each electronics heat exchanger 148 of FIG. 3, for example, may be configured as a mass of thermally conductive material such as metal with one or more internal fluid circuit passages 156A, 156B (generally referred to as "156"; one schematically shown in FIG. 3). These fluid circuit passages 156 collectively form a section of the respective circuit path 146 through the respective electronics heat exchanger 148. Each electronics heat exchanger 148 of FIG. 3 is disposed within the interior of the respective controller housing 120, where a sidewall 158A, 158B (generally referred to as "158") of each controller housing 120A, 120B forms a peripheral boundary of the EM controller housing interior. The electronics heat exchanger 148 may be connected to the housing sidewall 158 through the respective working fluid-to-air heat exchanger 150. The electrical circuitry 122 may be mounted to and/or otherwise arranged in thermal communication with the respective electronics heat exchanger 148. Here, each electronics heat exchanger 148 of FIG. 3 is disposed between and engages (e.g., contacts) (a) the respective electrical circuitry 122 and (b) the respective working fluid-to-air heat exchanger 150.

Each working fluid-to-air heat exchanger 150 may be configured as or otherwise include a radiator for the respective fluid circuit 142. Each working fluid-to-air heat exchanger 150 of FIG. 3, for example, includes a heat exchange base 160A, 160B (generally referred to as "160") and one or more heat exchange members 162A, 162B (generally referred to as "162").

Each heat exchange base 160 is configured as a mass of thermally conductive material such as metal with one or more internal fluid circuit passages 164A, 164B (generally referred to as "164"; one schematically shown in FIG. 3). These fluid circuit passages 164 collectively form a section of the respective circuit path 146 through the respective working fluid-to-air heat exchanger 150. Each heat exchange base 160 may be disposed within the interior of the respective controller housing 120. Each heat exchange base 160 of FIG. 3 is connected to, formed as an integral part of and/or otherwise arranged with respective housing sidewall 158. Each heat exchange base 160 may also be formed integral with or otherwise attached to the respective electronics heat exchanger 148. More particularly, for each fluid circuit 142, the working fluid-to-air heat exchanger 150 and the electronics heat exchanger 148 are collectively formed together as parts of a common heat exchanger / heat exchange structure. The present invention, however, is not limited to such an integrated arrangement. For example, it is contemplated the working fluid-to-air heat exchanger 150 and the electronics heat exchanger 148 for a respective fluid circuit 142 may alternatively be configured as discrete heat exchange structures which are attached to one another or physically separated from one another.

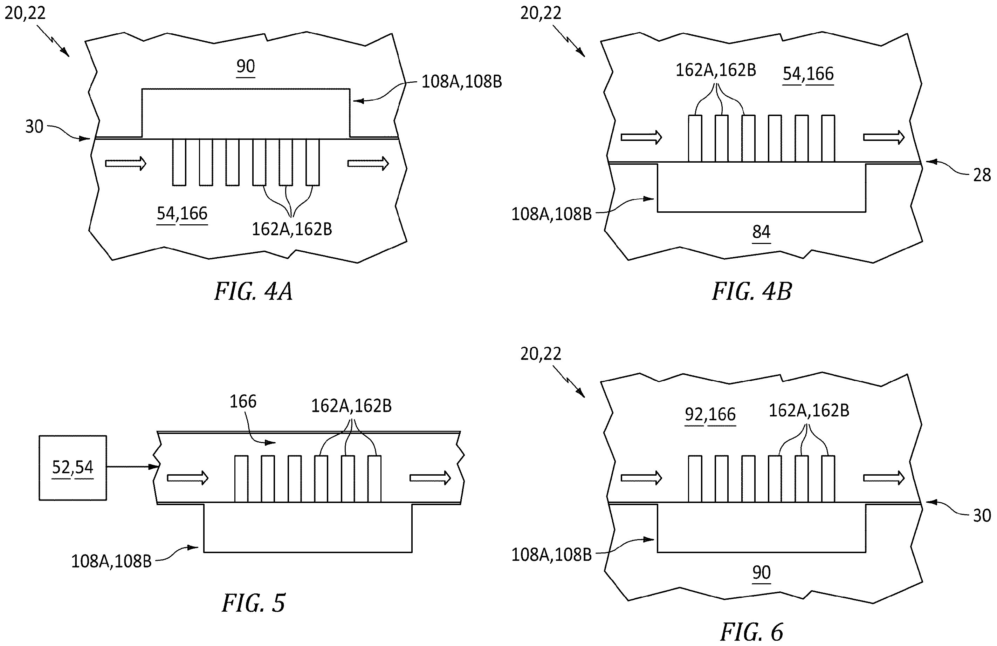

Each heat exchange member 162 may be configured as a cooling fin, a cooling pedestal or other cooling feature. Each heat exchange member 162 may be formed integral with or otherwise connected to the respective heat exchange base 160. Each heat exchange member 162 projects out from the heat exchange base 160 and/or the housing sidewall 158 (e.g., where the heat exchange base 160 is formed integral with the housing sidewall 158) partially into an environment within a volume 166 external to the respective EM controller 108. Referring to FIGS. 4A and 4B, the external volume 166 may be the bypass flowpath 54. Alternatively, referring to FIG. 5, the external volume 166 may be another passage or flowpath within the aircraft propulsion system 22 which receives a flow of air (e.g., bleed air) from the bypass flowpath 54 or the core flowpath 52. Still alternatively, referring to FIG. 6, the external volume 166 may be the external environment 92. The present invention, however, is not limited to the foregoing exemplary external volumes. Moreover, while the heat exchange members 162 are shown in FIG. 3 as solid members, it is contemplated one or more of the heat exchange members 162 may each alternatively be tubular and configured to define a respective portion of one of the fluid circuit passages 164.

Each fluid reservoir 152 is configured to contain a quantity of the respective working fluid before, during and/or after working fluid system operation. Each fluid reservoir 152, for example, may be configured as or otherwise include a tank, a cylinder, a pressure vessel, a bladder or any other type of (e.g., liquid) storage container. Each fluid reservoir 152 may be configured as un-vented fluid reservoir. Each fluid reservoir 152 of FIG. 3 is disposed within the interior of the respective controller housing 120.

Each fluid pump 154 is configured to direct and/or regulate a flow of the respective working fluid through the respective circuit path 146 from an outlet from (e.g., a supply of) the respective fluid reservoir 152, through the respective set of the fluid circuit components 148 and 150, to an inlet into (e.g., a return of) the respective fluid reservoir 152. Each fluid pump 154 of FIG. 3 is disposed within the interior of the respective controller housing 120. Each fluid pump 154 may be an electric pump controlled by, for example, the respective electrical circuitry 122.

During operation of each fluid circuit 142 of FIG. 3, the fluid pump 154 directs (e.g., pumps) relatively cool working fluid out of the fluid reservoir 152, through the circuit path 146, into the electronics heat exchanger 148 in thermal communication with the electrical circuitry 122 of the respective EM controller 108. As the working fluid flows through the electronics heat exchanger 148, heat energy generated by the electrical circuitry 122 of the respective EM controller 108 may be transferred into the working fluid. The heat energy transfer may thereby dissipate the heat energy in (e.g., cool) the electrical circuitry 122 of the respective EM controller 108 while also heating the working fluid. The now heated working fluid is directed away from the electronics heat exchanger 148, through the circuit path 146, to the working fluid-to-air heat exchanger 150. Within the working fluid-to-air heat exchanger 150, at least some or all of the heat energy previously transferred into the working fluid from the electrical circuitry 122 of the respective EM controller 108 is transferred out of the working fluid into the air flowing within the external volume 166 utilizing the heat exchange members 162, thereby cooling the working fluid. The now cooled working fluid is directed from the working fluid-to-air heat exchanger 150, through the circuit path 146, back into the fluid reservoir 152 for subsequent recirculation.

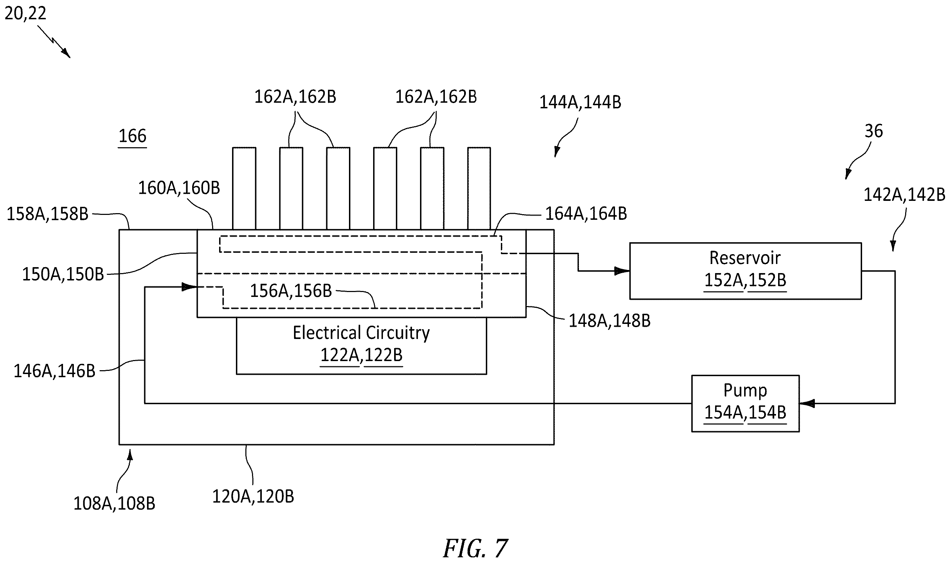

In some embodiments, referring to FIG. 3, each circuit path 146 is (e.g., completely) contained within the interior of the respective controller housing 120. Each fluid circuit component 148, 150, 152, 154 along that circuit path 146 is also at least partially or completely disposed within the interior of the respective controller housing 120. In other embodiments, referring to FIG. 7, one or more of the fluid circuit components such as the fluid reservoir 152 and/or the fluid pump 154 may alternatively be disposed outside of the respective controller housing 120. A section of the circuit path 146 of FIG. 7 is thereby also disposed outside of the respective controller housing 120.

In some embodiments, referring to FIG. 4A, each EM controller 108 may be arranged with the outer housing structure 30 and/or to the outer peripheral boundary of the bypass flowpath 54. In other embodiments, referring to FIG. 4B, each EM controller 108 may be arranged with the inner housing structure 28 and/or to the inner peripheral boundary of the bypass flowpath 54. Of course, it is contemplated each EM controller 108 may be alternatively arranged within the aircraft propulsion system 22 or even outside of the aircraft propulsion system 22; e.g., with a pylon structure mounting the aircraft propulsion system 22 to a component (e.g., an aircraft wing or an aircraft fuselage) of an airframe of the aircraft.

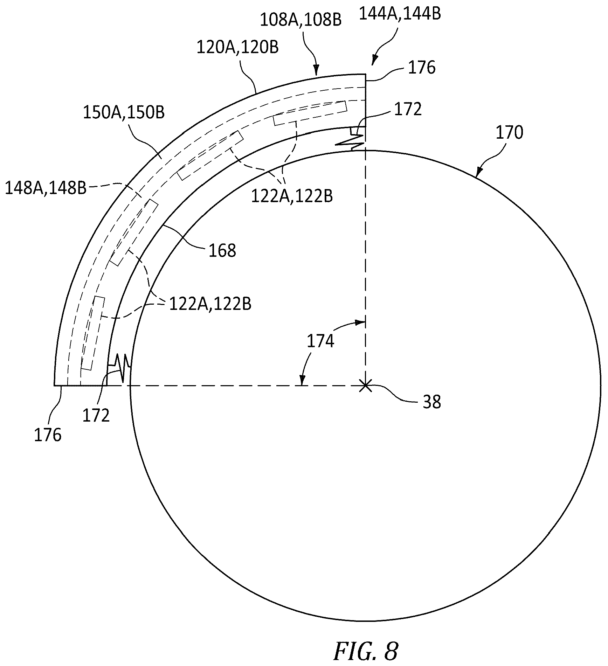

In some embodiments, referring to FIG. 8, each module 144 and one or more of its members (e.g., 108, 120, 148 and/or 150) may each have a curved (e.g., arcuate, splined, etc.) sectional geometry when viewed, for example, in a reference plane perpendicular to the propulsion system axis 38. An exterior surface 168 of the module 144 of FIG. 8, for example, has a geometry (e.g., a cylindrical segment geometry) tailored to substantially match (e.g., conform to, have an identical shape as, etc.) a geometry of a structure 170 (e.g., the engine case 80 or 86 of FIG. 1) to which that module 144 is mounted. The module 144 of FIG. 8 may be radially spaced (e.g., outboard from) the structure 170 by a radial air gap. This air gap may accommodate deformations in the structure 170 without affecting a structure of the module 144. Moreover, the module 144 of FIG. 8 may be flexibly mounted to the structure 170 to reduce transmission of vibrations from the structure 170 into the electrical circuitry 122. The module 144 of FIG. 8, for example, is mounted to the structure 170 through one or more flexible mounts 172; e.g., spring mounts, rubber mounts, etc.

The module 144 of FIG. 8 and one or more of its members (e.g., 108, 120, 148 and/or 150) may each extend circumferentially about the propulsion system axis 38. More particularly, the module 144 of FIG. 8 extends circumferentially about the propulsion system axis 38 a select number of degrees 174 between opposing circumferential ends 176 of that module 144. This number of degrees 174 may be greater than ten degrees (10°) and/or less than one-hundred and twenty degrees (120°).

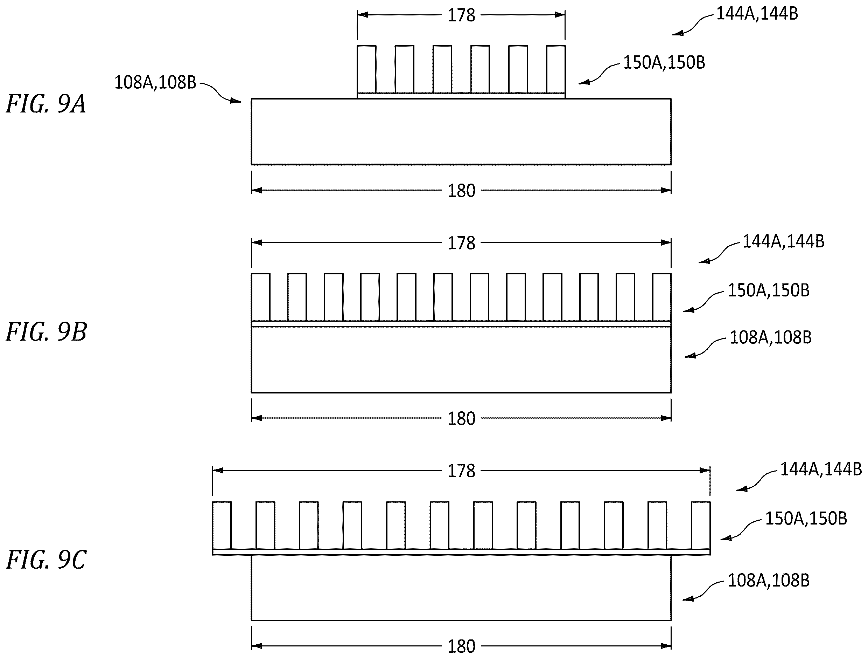

In some embodiments, referring to FIG. 9A, a dimension 178 (e.g., an axial length) of each working fluid-to-air heat exchanger 150 may be less than a (e.g., an axial length) dimension 180 of the respective EM controller 108 along a common axis; e.g., the propulsion system axis 38 of FIG. 1. In other embodiments, referring to FIG. 9B, the heat exchanger dimension 178 may be equal to the controller dimension 180. In still other embodiments, referring to FIG. 9C, the heat exchanger dimension 178 may be greater than the controller dimension 180. A ratio of the heat exchanger dimension 178 to the controller dimension 180 (e.g., the heat exchanger dimension 178 / the controller dimension 180) may be between 0.5 and 2.0, inclusive.

While the fluid circuits 142 are described above as servicing (e.g., cooling) the EM controllers 108 and their electrical circuitry 122, the present invention is not limited thereto. For example, it is contemplated the fluid circuits 142 may also or alternatively service (e.g., cool) other powerplant electronics. Examples of these other powerplant electronics include, but are not limited to, various other components of the aircraft electrical system 104 such as the electrical distribution bus 126 (see FIG. 2).

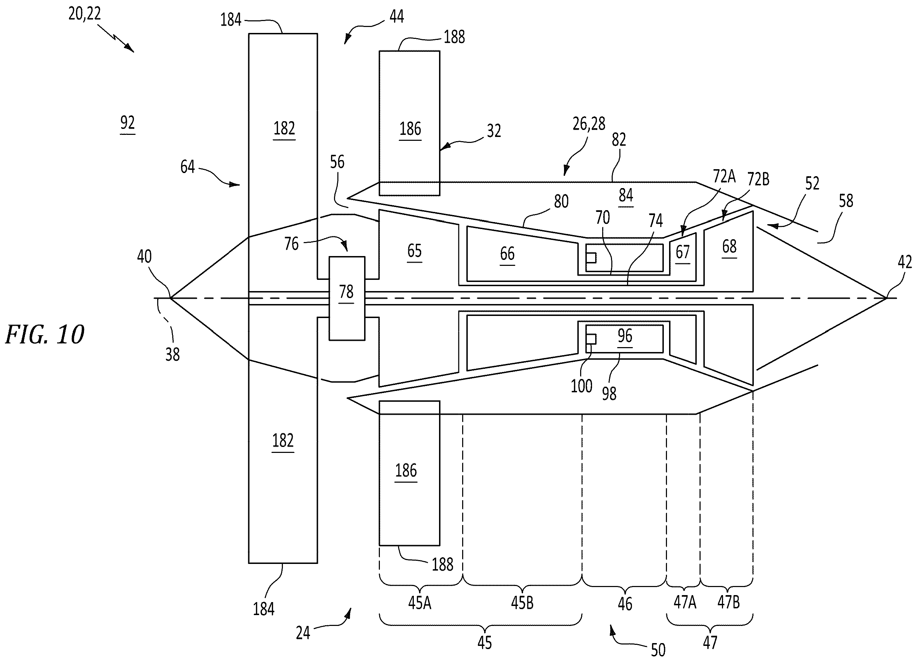

The aircraft propulsion system 22 of FIG. 1 is described above as a ducted propulsor propulsion system; e.g., the turbofan propulsion system. The present invention, however, is not limited to such an exemplary aircraft propulsion system. For example, referring to FIG. 10, the outer housing structure 30 (see FIG. 1) may be omitted from the propulsion system housing 26 to open the propulsor rotor 64 up to the external environment 92. More particularly, the propulsor rotor 64 of FIG. 10 includes a plurality of open propulsor blades 182 arranged circumferentially about the propulsion system axis 38 in an array; e.g., a circular array. This array of the propulsor blades 182 may be unshrouded or alternatively shrouded by a tubular propulsor rotor shroud dedicated to the propulsor rotor 64 for example. Each of these propulsor blades 182 projects spanwise (e.g., radially) out from a base of the propulsor rotor 64, into the external environment 92, to a distal tip 184 of the respective propulsor blade 182. Each propulsor blade 182 is thereby configured as an un-ducted propulsor blade which is exposed to (e.g., disposed in) the surrounding external environment 92. With this arrangement, the propulsor rotor 64 is an open propulsor rotor (e.g., an un-ducted propulsor rotor) and the aircraft propulsion system 22 is configured as an open rotor propulsion system. Moreover, the inner housing structure 28 and its nacelle structure 82 may form an exterior of the aircraft propulsion system 22 and may border the external environment 92.

The guide vane structure 32 may also be open to the external environment 92 forming an open guide vane structure. This guide vane structure 32 of FIG. 10 includes a plurality of open exit guide vanes 186; e.g., airfoils. The guide vanes 186 are arranged and may (or may not) be equispaced circumferentially about the propulsion system axis 38 in an array; e.g., a circular array. This array of the guide vanes 186 may be unshrouded or alternatively shrouded by a tubular guide vane shroud dedicated to the guide vane structure 32 for example. This guide vane structure 32 and its guide vanes 186 are arranged axially next to (e.g., adjacent) the propulsor rotor 64 and its propulsor blades 182. The guide vane structure 32 and its guide vanes 186 of FIG. 10, for example, are arranged downstream of the propulsor rotor 64 and its propulsor blades 182, without (e.g., any) other elements axially therebetween to obstruct, turn and/or otherwise influence the air propelled by the propulsor rotor 64 to the guide vane structure 32. Each of the guide vanes 186 projects radially out from an exterior surface of the inner housing structure 28, into the external environment 92, to a distal tip 188 of the respective guide vane 186. Each guide vane 186 is thereby configured as an un-ducted guide vane which is exposed to (e.g., disposed in) the surrounding external environment 92. With the foregoing arrangement, the guide vane structure 32 and its guide vanes 186 are configured to condition (e.g., straighten out, de-swirl, etc.) an outer stream of air propelled by the propulsor rotor 64 within the external environment 92 that bypass the engine core 50. Of course, in other embodiments, the guide vane structure 32 may be omitted where, for example, the aircraft propulsion system 22 is alternatively configured as a counter-rotating open rotor (CROR) aircraft propulsion system, etc.

While the turbine engine 24 in FIG. 1 and FIG. 10 is shown with a particular two rotating structure arrangement, the present invention is not limited thereto. For example, the LPC rotor 65 may be omitted to configure the LPT rotor 68 as a power turbine (PT) rotor for the propulsor rotor 64. In another example, the turbine engine 24 may also include another rotating structure; e.g., an intermediate speed spool for the turbine engine 24 and its engine core 50.

While various embodiments of the present invention have been described, it will be apparent to those of ordinary skill in the art that many more embodiments and implementations are possible within the scope of the invention. For example, the present invention as described herein includes several aspects and embodiments that include particular features. Although these features may be described individually, it is within the scope of the present invention that some or all of these features may be combined with any one of the aspects and remain within the scope of the invention. Accordingly, the present invention is not to be restricted except in light of the attached claims and their equivalents.

## Claims

1. An assembly for an aircraft powerplant, comprising:
an electric device including a device housing and electrical circuitry housed within an interior of the device housing; and
a closed loop fluid circuit configured to cool the electrical circuitry, the closed loop fluid circuit including a circuit path and a plurality of circuit components, the circuit path extending through the plurality of circuit components, each of the plurality of circuit components at least partially housed within the interior of the device housing, and the plurality of circuit components comprising a heat exchanger.

2. The assembly of claim 1, wherein:
the heat exchanger comprises a cooling plate; and
the electrical circuitry is thermally coupled to the cooling plate within the interior of the device housing.

3. The assembly of claim 2, wherein the electrical circuitry is mounted to the cooling plate.

4. The assembly of any of claims 1 to 3, wherein the heat exchanger further comprises a cooling element projecting into an environment external to the electric device.

5. The assembly of claim 1, wherein the heat exchanger comprises a radiator with a plurality of cooling elements disposed in an environment external to the electric device.

6. The assembly of claim 5, further comprising a cooling plate, the electrical circuitry thermally coupled to the cooling plate within the interior of the device housing, and the circuit path extending through the cooling plate.

7. The assembly of claim 6, wherein the cooling plate is formed integral with the radiator.

8. The assembly of any preceding claim, wherein the plurality of circuit components further comprises a fluid reservoir.

9. The assembly of any preceding claim, wherein the plurality of circuit components further comprises a fluid pump.

10. The assembly of any preceding claim, wherein the circuit path is contained within the interior of the device housing.

11. The assembly of any preceding claim, wherein the closed loop fluid circuit further comprises a fluid reservoir or a fluid pump disposed outside of the electric device.

12. The assembly of any preceding claim, wherein the electric device is configured as an electronic controller.

13. The assembly of claim 12, further comprising:
an electric machine configurable as at least one of an electric motor or an electric generator, the electronic controller configured to control operation of the electric machine, and optionally:
a rotating structure comprising a bladed rotor, the rotating structure operatively coupled to the electric machine.

14. The assembly of any claim 1, further comprising a turbine engine comprising an engine case, the electric device mounted to the engine case, optionally wherein:
the engine case extends circumferentially about an axis; and
the electric device follows a contour of the engine case circumferentially about the axis.

15. The assembly of any preceding claim, wherein the electric device has a curved sectional geometry.
